**Europäisches Patentamt**

**European Patent Office**

**Office européen des brevets**

(11) Publication number: **0 262 830**
**A2**

## (12) EUROPEAN PATENT APPLICATION

(21) Application number: **87308110.3**

(22) Date of filing: **15.09.87**

(51) Int. Cl.4: **H01L 21/285**

The title of the invention has been amended (Guidelines for Examination in the EPO, A-III, 7.3).

(30) Priority: **03.10.86 GB 8623788**

(43) Date of publication of application:
**06.04.88 Bulletin 88/14**

(84) Designated Contracting States:
**AT BE CH DE ES FR GB GR IT LI LU NL SE**

(71) Applicant: **THORN EMI plc**
**4 Tenterden Street**
**London W1R 9AH(GB)**

(72) Inventor: **Sibbald, Alastair**
**18 Horseguards Drive**
**Maidenhead Berkshire, SL6 1XL(GB)**

(74) Representative: **Marsh, Robin Geoffrey et al**
**Thorn EMI Patents Limited The Quadrangle**
**Westmount Centre Uxbridge Road**
**Hayes Middlesex, UB4 0HB(GB)**

(54) **Method of ensuring contact in a deposited layer.**

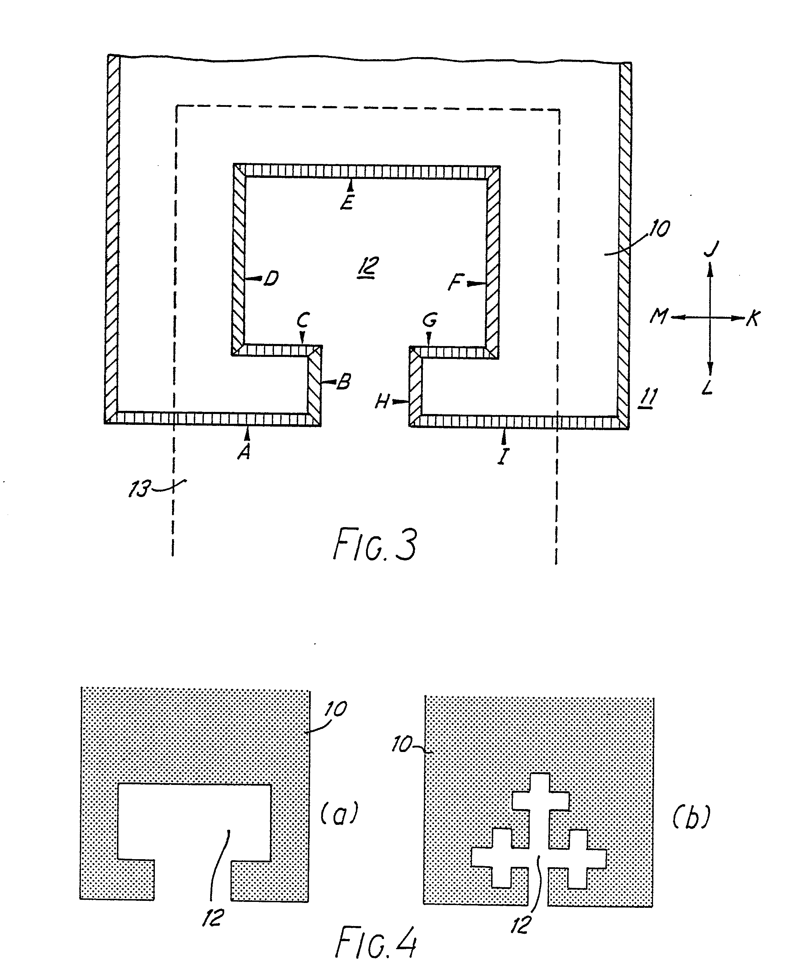

(57) An electrical device such as a metal-oxide-semi-conductor field effect device has a layer (10) of a first material (eg $SiO_2$) having an edge (A) and an overlying layer (13) of a second material (eg a metallisation). The edge is configured to define an indentation or projection (12) which presents a number of edge surfaces (B, C...H) arranged at different relative orientations to one another. Coverage of at least one of the edge surfaces will be substantially continuous even if an anisotropic deposition technique is used to deposit the overlying layer (13). Each indentation or projection may have a fractal form (Fig 4b) including a number of identical edge patterns.

FIG. 3

## AN ELECTRICAL DEVICE AND A METHOD FOR MANUFACTURING AN ELECTRICAL DEVICE

This invention relates to an electrical device and it relates particularly, though not exclusively, to an electrical device manufactured using so-called planar fabrication techniques. The invention also relates to a method for manufacturing an electrical device.

Many electrical devices e.g. a MOS field effect transistor are manufactured using so-called planar fabrication techniques whereby individual elements of a device are formed in a single plane, typically at a surface of a single crystal of silicon. Since, in general, several processing stages may be needed to fabricate the device, the surface topology of the crystal is found, in practice, to be far from planar and may contain steep edges, some as deep as 2μm.

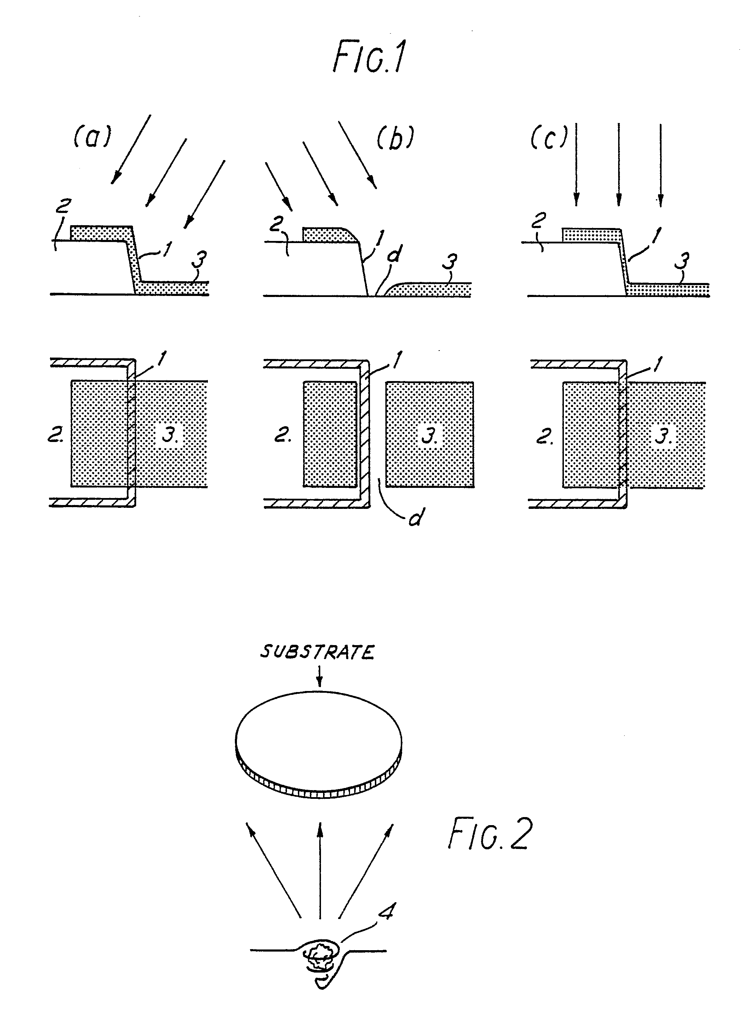

These edges can be troublesome if a thin, continuous layer is to be deposited at the crystal surface, especially if the layer thickness is less than, or similar to, the depth of an edge. This problem is illustrated generally by reference to Figures 1a, 1b and 1c of the accompanying drawings which show cross-sectional views through an edge 1 of an epitaxial layer 2 formed on a substrate. Typically, the edge would be formed by etching the epitaxial layer using a suitable photolithographic technique and, as is usually the case when a wet etch is used, the edge would be slightly bevelled, as shown, due to undercutting of a photoresist which is normally applied to the epitaxal layer during the etch process.

It will be assumed, in this example, that a layer 3 (a metallisation, say) is deposited on layer 2 by thermal evaporation and, as shown in Figure 2 of the drawings, an evaporant produced by a heated source 4 would be incident at a receiving surface over a range of angles. If, as is shown in Figure 1a, the evaporant is directed towards edge 1, then coverage may be acceptable. If, however, the evaporant is directed away from the edge, as shown in Figure 1b, then the edge, in effect, casts a "shadow" giving rise to a discontinuity (d) in the deposited layer. If, on the other hand, the evaporant is directed at an intermediate angle, as shown in Figure 1c, layer 3 deposited at the edge may be relatively thin. A thin layer may be prone to cracking due to thermal stress and, in the case of a metallisation, could give rise to an electrical discontinuity. Moreover, because the local electrical resistivity tends to be relatively high where the deposition is thin the layer may also be susceptible to burn out and/or electromigration. In practice, it is expected that the yield of useful deposition layers might be somewhat less than 50%.

A problem may be encountered by forming an electrical contact with the drain, source, or semiconductor bulb regions of a metal-oxide-semiconductor field effect transistor (MOSFET). In this case a metallisation layer, typically 1μm thick, must be deposited on the sides of a contact hole, typically 1μm deep, which is formed in the field oxide layer of the MOSFET thereby to expose a region with which an electrical contact is to be established.

A similar problem may be encountered in forming an electrical contact with the gate region of a MOSFET, with a gate electrode, in the form of a metallisation layer, overlying an edge defined by a difference of level between the gate oxide layer, typically 0.1μm thick, and the field oxide layer, typically 1μm thick. In this case, the problem is much more severe because the gate electrode usually comprises an ultra-thin metallisation layer, typically only 5-10 nm thick, which is preferably deposited by thermal evaporation. In some forms of MOSFET the gate electrode is made of a catalytically active metal such as platinum or palladium and, in these circumstances, a separate contact strip, typically 1μm thick, is often used to connect the gate electrode to a bonding pad. The gate electrode, which again may be only 5-10 m thick, must then overlie edges due to the contact strip and the field oxide layer.

Edge coverage problems may also be encountered in other contexts. For example, some devices such as microwave devices, power transistors and power rectifiers are fabricated so as to be intrinsically non-planar. Also in some VLSI applications complex interconnections are required wherein two or more metallisation layers are arranged in stacked relationship with thin insulating layers of $SiO_2$ or polyimide separating the layers. With this kind of construction a metallisation layer may cross one or more edges created by an underlying metallisation layer and/or insulation layer.

It will be apparent from the afore-mentioned examples that edge-coverage problems abound in the manufacture of electrical devices, and it is one object of this invention to provide an improved fabrication technique whereby these problems may at least be alleviated.

According to one aspect of the invention, there is provided an electrical device including a layer of a first material having an edge and a layer of a second material overlying said edge wherein the edge is configured to define an indentation in, or a projection of, said layer of a first material, said indentation or projection presenting a number of edge surfaces arranged at different relative orientations to one another so that coverage of at least one of the edge surfaces by said second material is substantially continuous.

The inventor finds that improved coverage can be achieved even if an anisotropic deposition technique, such as thermal evaporation, is used.

Said indentation or projection may have a fractal form including a group of identical edge patterns and each pattern may define a cross.

Said edge may be configured to define an array of said indentations or projections, for example a linear array of identical said indentations or projections.

In a specific example of the invention, the electrical device may be a metal-oxide-semiconductor field effect transistor wherein said layer of a first material comprises a field oxide layer, said edge region bounds a contact hole formed in the field oxide layer and said layer of a second material comprises a metallisation for establishing an electrical contact with a surface exposed by the contact hole.

Said contact hole may expose the drain, source or semiconductor bulk regions of the device, or alternatively said contact hole may expose a gate insulation layer of the device.

According to a second aspect of the invention there is provided a method for manufacturing an electrical device including the processing stages of providing a layer of a first material having an edge configured to define an indentation in, or a projection of the layer, and depositing a layer of a second material to overlie said indentation or projection, wherein said indentation or projection presents a number of edge surfaces which are arranged at different relative orientations to one another thereby to promote substantially continuous coverage by said second material of at least one of the edge surfaces.

In order that the invention may be carried readily into effect an embodiment thereof is now described by way of example only, by reference to the accompanying drawings of which,

Figures 1a, 1b and 1c show cross-sectional views through an epitaxial layer presenting an edge,

Figure 2 illustrates a thermal evaporation process,

Figure 3 shows a plan view of an epitaxial layer having an edge which is configured in accordance with the present invention,

Figures 4a and 4b show plan views of an epitaxial layer having an edge configured to define differently shaped identations,

Figure 5 shows a plan view of an epitaxial layer having an edge configured to define an array of identations and

Figure 6 shows a plan view of an epitaxial layer having an edge which is configured to define a projection.

Figure 3 of the drawings shows a plan view of an epitaxial layer 10 formed on a flat substrate 11 as in Figures 1. In accordance with the present invention, layer 10 has an edge, identified by the shaded regions in the drawing, which is configured to define an indentation 12 in the layer, and a layer 13, represented in broken outline, overlies the indentation.

As will be appreciated by persons skilled in the art layer 10 may be suitably patterned to produce the indentation by etching, using a known photolithographic technique.

In this example, it will be assumed that layer 10 comprises the field oxide layer of a gas-sensitive MOSFET and that layer 13 comprises an electro-active gate electrode in the form of an ultra-thin metallisation layer, typically 5-10 nm thick, of a calalytically active metal (eg Pt or Pd) which is deposited by thermal evaporation. It will be appreciated, however, that the present invention is applicable to other kinds of electrical device and that, in general, either layer 10 or layer 13 could comprise a metal, a semiconductor or an insulator, such as an oxide or an organic material.

Referring again to Figure 3, the indentation 12 is so shaped as to present a number of differently orientated edge surfaces (A-I), and the inventor finds that a substantially continuous coverage of at least one of these edge surfaces, by metallisation layer 13, can always be achieved even when an anisotropic deposition technique, such as thermal evaporation, is used.

Thus, for example, if an evaporant is incident in the direction designated J in the drawing, the edge surfaces A,E and I would receive an adequate coverage thereby ensuring electrical continuity of the metallisation layer. Similarly, if the evaporant is incident in directions K, M and L, the pairs of edge surfaces F,H; B,D and C,G respectively would be covered adequately.

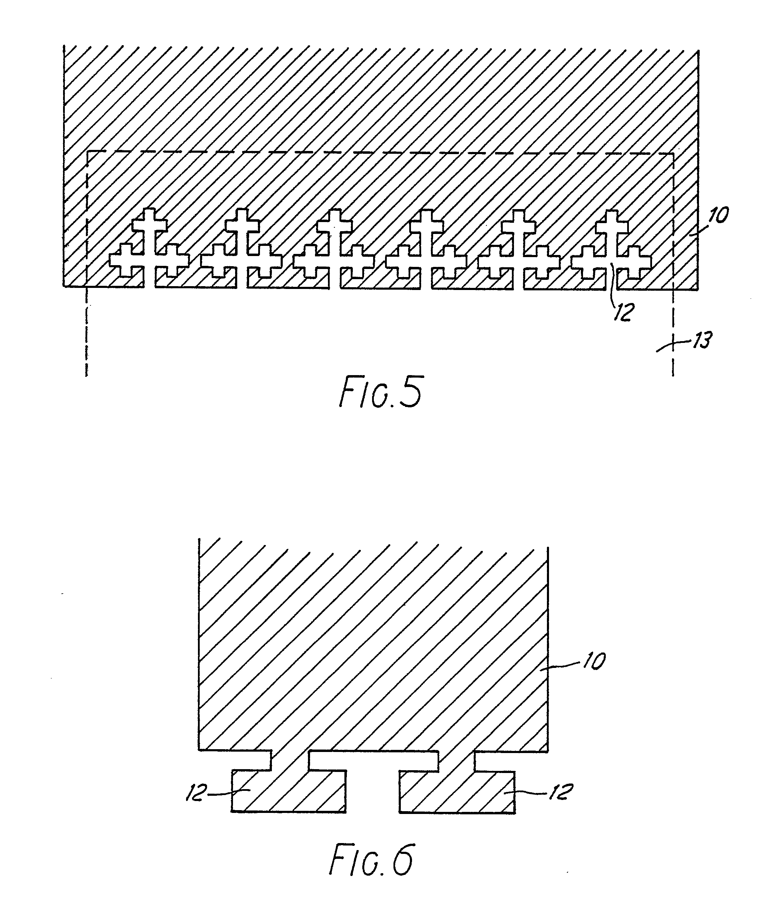

Coverage may be improved further by increasing the overall length of the edge surface presented by the indentation so that the metallisation layer, overlying the indentation, contacts a larger surface area. Also, this has the effect of reducing the electrical resistivity of the layer. An indentation having a complex edge pattern of the form shown in Figure 4b, for example, presents edge surfaces having a total length which is about 62% greater than the total length of the edge surfaces presented by a rectangularly-shaped indentation of the same area, as shown in Figure 4a. The fractal form shown by way of example in Figure 4b comprises a group of identical edge patterns (three in this case), each defining a cross. Benefit may also accrue by providing a number of indentations which are arranged in a linear array, as shown in Figure 5 for example.

It will be understood that while the examples described hereinbefore relate to an indentation formed in a epitaxial layer, the present invention also embraces embodiments wherein the layer is formed with a projection having a number of differently orientated edge surfaces, as shown by way of example in Figure 6.

It will be appreciated that although the present invention is particularly, though not exclusively, applicable to the fabrication of MOS devices, especially MOSFET chemical sensors, having electroactive gate electrodes, the present invention is also considered to be applicable, generally to fabrication of other electrical devices, components and circuits. The invention is also likely to find application in the fabrication of power semiconductor devices and may be useful in thin film waveguide coupling applications employed in integrated optics engineering.

## Claims

1. An electrical device includes a layer of a first material having an edge and a layer of a second material overlying said edge, wherein said edge is configured to define an indentation in, or a projection of, said layer of a first material, said indentation or projection presenting a number of edge surfaces arranged at different relative orientations to one another so as to promote substantially continuous coverage of at least one of the edge surfaces even if said layer of a second material is deposited by an anisotropic deposition technique.

2. An electrical device according to Claim 1 wherein each said indentation or projection has a fractal form including a group of identical edge patterns.

3. An electrical device according to Claim 2 wherein each said edge pattern defines a cross.

4. An electrical device according to any one of Claims 1 to 3 wherein said edge is configured to define an array of said indentations or projections.

5. An electrical device according to Claim 4 wherein said edge is configured to define a linear array of identical said indentations or projections.

6. An electrical device according to any one of Claims 1 to 5 in the form of a metal-oxide-semiconductor field effect device wherein said layer of a first material comprises a field oxide layer of the device, said edge bounds a contact region formed in the field oxide layer and said layer of a second material comprises a metallisation for establishing an electrical contact with a surface exposed by the contact region.

7. An electrical device according to Claim 6 wherein said contact region comprises a contact hole which exposes the drain, source or semiconductor bulk regions of the device.

8. An electrical device according to Claim 6 wherein said contact region exposed a gate region of the device.

9. A method of manufacturing an electrical device including the processing stages of providing a layer of a first material having an edge configured to define an indentation in, or a projection of, the layer and depositing a layer of a second material to overlie said indentation or projection, wherein said indentation or projection presents a number of edge surfaces which are arranged at different relative orientations to one another thereby to promote substantially continuous coverage by said second material of at least one of the edge surfaces even if said layer of a second material is deposited by an anisotropic deposition technique.

10. A method according to Claim 9 including depositing said layer of a said material by an anisotropic deposition technique.

## FIG.1

## FIG.2

SUBSTRATE

FIG.3

FIG.4

0 262 830

FIG. 5

FIG. 6